# EUROPÄISCHE PATENTSCHRIFT

(11) **EP 2 739 767 B1**
(45) Veröffentlichungstag und Bekanntmachung des Hinweises auf die Patenterteilung: **15.02.2017**
(21) Anmeldenummer: 12745406.4
(22) Anmeldetag: 02.08.2012
(51) Int. Cl.: C23C 4/134, C23C 16/513, F16B 2/00

(54) **Herstellung einer REIBWERTERHÖHENDEn BESCHICHTUNG MITTELS ATMOSPHÄRENDRUCKPLASMA-BESCHICHTUNG**
PRODUCTION of a COATING INCREASING THE FRICTION COEFFICIENT BY MEANS OF ATMOSPHERIC PRESSURE PLASMA COATING
PRODUCTION D'un REVÊTEMENT AUGMENTANT LE COEFFICIENT D'ADHÉRENCE PAR UN PLASMA SOUS PRESSION ATMOSPHÉRIQUE

(30) Priorität: 05.08.2011 DE 102011052447
(43) Veröffentlichungstag der Anmeldung: 11.06.2014
(73) Patentinhaber: IP plasma & brands GmbH, 85053 Ingolstadt (DE)
(72) Erfinder: SPETH, Willy, 85283 Wolnzach (DE)
(74) Vertreter: Kuhnen & Wacker
(86) Internationale Anmeldenummer: PCT/EP2012/003307
(87) Internationale Veröffentlichungsnummer: WO 2013/020679

(56) Entgegenhaltungen:
- EP-A1- 1 300 485
- WO-A1-2010/104442
- DE-A1-102008 017 029
- US-A- 3 692 341
- US-A1- 2010 304 045

## Beschreibung

Die Erfindung betrifft ein Verfahren zur Herstellung einer reibwerterhöhenden Beschichtung mittels nicht-thermischer Atmosphärendruckplasma-Beschichtung sowie ein Bauteil mit einer reibwerterhöhenden Beschichtung, die mit dem zuvor genannten Verfahren hergestellt ist.

Kraftschlüssige Verbindungen dienen bei Bauteilen und Komponenten dazu Kräfte zu übertragen. Insbesondere in allen Bereichen des Maschinenbaus wird diese Verbindungsart zur Übertragung von Drehmomenten und Querkräften eingesetzt. Dabei bestimmen Adhäsionskräfte die Höhe der zwischen den kraftschlüssig miteinander verbundenen Fügeflächen übertragbaren Querkräfte. Als Maß dafür, mit welchem Anteil eine Querkraft gegenüber einer anliegenden Normalkraft noch angelegt werden kann bevor ein "Gleiten" erfolgt, dient der Haftbeiwert v. Er hängt ab von der für die kraftschlüssige Verbindung verwendeten Werkstoffpaarung, Rauheit, Schmierungszustand und Beanspruchung der Fügeflächen. Bei einer trockenen Verbindung von Stahloberflächen beträgt der Haftbeiwert ν etwa 0,15.

Eine Erhöhung des Haftbeiwerts ν kann durch reibwerterhöhende Beschichtungen erzielt werden. Im Stand der Technik werden zum Herstellen einer reibwerterhöhenden Beschichtung Hartpartikel in einem Galvanisierungsbad zusammen mit einer als Matrixschicht dienenden Metallschicht auf die Oberfläche eines Bauteils aufgebracht. Die in dem Galvanisierungsbad dispergierten Hartpartikel werden hierbei in die im Bad anwachsende Metallschicht eingebaut. Das Material für die Hartpartikel besitzt eine höhere Druck- und Scherfestigkeit als das der Fügeflächen, sodass die Hartpartikel einen zusätzlichen Formschluss (im µm-Bereich) ermöglichen indem diese bei entsprechender Normalkraft in die Bauteiloberflächen teilweise eindringen.

Nachteil des Herstellens einer reibwerterhöhenden Beschichtung durch den kontinuierlichen Einbau von in dem Galvanisierungsbad dispergierten Hartpartikeln in eine Matrixschicht ist, dass die am Ende des Beschichtungsvorgangs eingebauten Partikel nur zum geringen Teil von der Matrixschicht umschlossen sind und daher darin nicht fest verankert sind. Die am Ende des Beschichtungsvorgangs eingebauten Partikel neigen deshalb bei diesem Verfahren zur Ablösung. Als Lösung für dieses Problem wird in der DE 101 48 831 A1 ein Mehrschichtmatrixsystem vorgeschlagen, bei dessen Herstellung das Galvanisierungsbad für die zuletzt aufgebrachte Matrixschicht keine darin dispergierten Hartpartikel aufweist, um sicherzustellen, dass alle Hartpartikel in dem Matrixschichtsystem fest verankert sind. Jedoch können bei Mehrschichtmatrixsystemen Fehlstellen in den Grenzflächen zwischen den Matrixschichten auftreten und es infolgedessen zu einer Ablösung einer oder mehrerer Schichten kommen. Die Ablösung von Hartpartikeln oder von Matrixschichten stellt für die Anwendung der beschichteten Bauteile im Betrieb ein großes Problem dar, da abgelöste Hartstoffpartikel oder Matrixschichten zu vorzeitigem Verschleiß oder zu einem Funktionsausfall führen können.

Ein weiterer Nachteil des Herstellens von reibwerterhöhenden Beschichtungen in Galvansisierungsbädern liegt bei großen sperrigen Bauteilen darin, dass auch die Galvansisierungsbäder dementsprechend groß dimensioniert sein müssen, und das Verfahren dadurch aufwendig und unwirtschaftlich wird. Zudem müssen beim Herstellen einer reibwerterhöhenden Beschichtung in einem Galvanisierungsbad Oberflächenbereiche des zu beschichtenden Bauteils, auf die keine reibwerterhöhende Beschichtung aufgebracht werden soll, vor dem Eintauchen des Bauteils in das Galvanisierungsbad aufwendig maskiert werden. Bei kompliziert geformten Bauteilen kann eine Maskierung bestimmter Oberflächenbereiche auch gänzlich unmöglich sein. Um die Probleme beim Herstellen einer reibwerterhöhenden Beschichtung auf großen und/oder kompliziert geformten Bauteilen zu umgehen, wird in der DE 198 23 928 A1 vorgeschlagen, eine separate, dünne, flexible Schicht mit darin eingebauten Partikeln als Verbindungselement zwischen die Fügeflächen einer kraftschlüssigen Verbindung einzulegen anstatt reibwerterhöhende Beschichtungen direkt auf den Fügeflächen abzuscheiden. Jedoch bedeutet die Verwendung dieses zwischen die Fügeflächen einzubringenden separaten Verbindungselementes einen Zusatzaufwand bei der Montage von Bauteilen zur Herstellung einer kraftschlüssigen Verbindung.

Aus der DE 10 2007 043 291 A1 ist die Herstellung von Beschichtungen bekannt, bei der ein für die Beschichtung verwendetes Pulver vor dem Aufbringen auf ein Substrat mit einem Atmosphärendruckplasma aktiviert wird. Jedoch ist es bisher nicht gelungen, damit reibwerterhöhende Beschichtungen guter Qualität abzuscheiden.

Aus der DE102008017029 A1 ist ein Verfahren zur Herstellung einer reibungserhöhenden Beschichtung bekannt.

Es ist Aufgabe der vorliegenden Erfindung, eine reibwerterhöhende Beschichtung auf Bauteilen mit einem Verfahren herzustellen, das die aus dem Stand der Technik bekannten Nachteile vermeidet. Insbesondere ist es Aufgabe der Erfindung, ein wirtschaftlicheres Verfahren bereitzustellen, mit dem reibwerterhöhende Beschichtungen hergestellt werden können, bei denen keine Gefahr der Ablösung von Partikeln und/oder von Matrixschichten besteht.

Die Aufgabe wird gelöst durch ein Herstellungsverfahren nach Anspruch 1. Mit dem erfindungsgemäßen Verfahren ist es in wirtschaftlicher Art und Weise möglich, auch bei großen und/oder kompliziert geformten Bauteilen eine reibwerterhöhende Beschichtung direkt auf die Oberfläche eine Bauteils aufzubringen. Bei dem erfindungsgemäßen Verfahren wird durch eine Ummantelung der Hartpartikel mit einem Haftmittler erreicht, dass sich die aufgebrachten Hartpartikel beim Transport und bei der Montage des Bauteils nicht von der Bauteiloberfläche ablösen.

Vorteilhafte Weiterbildungen der Erfindung sind in den Unteransprüchen angegeben.

Besonders hohe Haftbeiwerte von Bauteilen mit der reibwerterhöhenden Beschichtung lassen sich bei Verwendung von Diamant oder von Siliziumcarbid als Material für die Hartpartikel erzielen.

Bei einer bevorzugten Ausführungsform wird Metall als Haftmittler verwendet. Eine Metallummantelung ist besonders geeignet, eine vorzeitige Ablösung der Hartpartikel von der beschichteten Bauteiloberfläche zu verhindern.

Geringe Ablösung und hohe Haftbeiwerte zeigen mit dem erfindungsgemäßen Verfahren hergestellte Beschichtungen insbesondere bei einer bevorzugten Ausführungsform, bei der die Belegung der Hartpartikel mit Haftmittler nach der Beschichtung in Verfahrensschritt a) zwischen 20% und 80% der Hartpartikeloberfläche beträgt. Die besten Ergebnisse hinsichtlich der Ablöseeigenschaften und der Haftbeiwerte werden erzielt wenn die Belegung der Hartpartikel mit Haftmittler nach der Beschichtung in Verfahrensschritt a) zwischen 30% und 70% der Hartpartikeloberfläche beträgt.

Bei einer bevorzugten Ausführungsform beträgt der mittlere Durchmesser der Hartpartikel zwischen 3µm und 45µm. Besonders gute Eigenschaften können mit einem mittleren Durchmesser der Hartpartikel von 10µm bis 30µm erzielt werden.

Bei einer bevorzugten Ausführungsform des erfindungsgemäßen Verfahrens wird die beschichtete Oberfläche mittels eines Atmosphärendruckplasmas nachbehandelt. Dadurch lassen sich die Ablöseeigenschaften der reibwerterhöhenden Beschichtung weiter optimieren.

Bei einer bevorzugten Ausführungsform des erfindungsgemäßen Verfahrens bildet die in Verfahrensschritt b) gebildete reibwerterhöhende Beschichtung keine geschlossene Schicht zum Bauteil.

Besonders hohe Haftbeiwerte lassen sich erzielen, wenn die in Verfahrensschritt b) erzeugte reibwerterhöhende Beschichtung auf der Oberfläche des Bauteils eine gleichmäßige Flächenbelegung mit Hartpartikeln zwischen 10% und 30% der Oberfläche des Bauteils bildet.

Im Folgenden wird eine Ausführungsform der Erfindung beispielhaft anhand der beigefügten Figuren erläutert. In den Figuren zeigen:
- Fig. 1: einen teilweise mit einem Haftmittler ummantelten Partikel, wie er zur Herstellung einer reibwerterhöhenden Beschichtung mit dem erfindungsgemäßen Verfahren verwendet wird;
- Fig. 2: einen Querschnitt durch eine mit dem erfindungsgemäßen Verfahren hergestellte reibwerterhöhende Beschichtung auf einer als Fügefläche bestimmten Bauteiloberfläche; und
- Fig. 3: eine Draufsicht auf die in Fig. 2 dargestellte reibwerterhöhende Beschichtung.

Bei dem erfindungsgemäßen Verfahren werden Hartpartikel 1 verwendet, die mit einem Haftmittler 2 vollständig oder teilweise ummantelt sind. Dabei bestehen die Hartpartikel 1 aus einem harten Material wie z.B. Diamant, Siliziumcarbid (SiC), Borcarbid (B₄C), Wolframcarbid (WC), Nitriden, wie z.B. Siliziumnitrid (Si₃N₄) oder kubischem Bornitrid (c-BN), Borid, Siliziumdioxid (SiO₂) oder Aluminiumoxid (Al₂O₃). Diese Materialien zeichnen sich dadurch aus, dass sie bei den jeweiligen Einsatzbedingungen chemisch weder mit den Werkstoffen der zu fügenden Werkstücke noch mit den Umgebungsmedien reagieren, also chemisch inert sind. Zudem zeichnen sich diese Materialien für die Hartpartikel 1 dadurch aus, dass sie eine hohe Druck- und Scherfestigkeit aufweisen. Entscheidend für die Funktion der reibwerterhöhenden Beschichtung 3 ist, dass die Hartpartikel 1 eine höhere Druck- und Scherfestigkeit als das Material der Fügeflächen 5 besitzt, so dass die Hartpartikel 1 beim Zusammendrücken der Fügeflächen 5 einen zusätzlichen Formschluss ermöglichen, indem diese in die Bauteiloberflächen 5 teilweise eindringen, wie oben beim Stand der Technik beschrieben. Vorzugsweise bestehen die Hartpartikel 1 aus Siliziumcarbid oder Diamant. Der mittlere Durchmesser der bei dem Verfahren verwendeten Hartpartikel 1 beträgt 3 µm bis 45 µm, vorzugsweise 10 µm bis 30 µm. Die Größe der dabei verwendeten Hartpartikel 1 ergibt sich durch die Vorgabe, dass die Fügeflächen 5 nicht durch das Eindrücken der Hartpartikel 1 in die Fügeflächen 5 in unzulässigem Ausmaß beschädigt werden dürfen. Die Größenverteilung der Körnung besitzt eine Streuung von nicht mehr als +/- 50% um einen angegebenen Nominaldurchmesser.

Der für die Ummantelung der Hartpartikel 1 verwendete Haftmittler 2 besteht aus Polymer, Metall oder einer organischen Substanz.

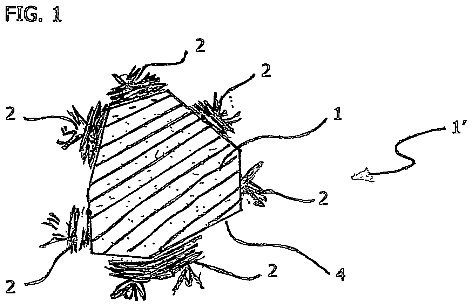

Bei der vorliegenden Ausführungsform wird ein metallischer Haftmittler 2 verwendet, der mittels chemischer Galvanisierung auf die Hartpartikel 1 aufgebracht wird. Ein mit dem Haftmittler 2 teilweise ummantelter Hartpartikel 1 ist in Fig. 1 gezeigt. Vorzugsweise beträgt die Belegung der Hartpartikel 1 mit Haftmittler 2 zwischen 20% und 80% der Hartpartikeloberfläche 4. Bei einer Belegung der Hartpartikel 1 mit Haftmittler 2 von weniger als 20% haften die Hartpartikel nicht mehr zuverlässig an der Oberfläche des Bauteils. Bei einer Belegung von mehr als 80% wird hingegen der Haftbeiwert gering, da ein zu hoher Anteil des Haftmittlers für Gleiteigenschaften der Hartpartikel im Fügespalt verantwortlich ist. Als besonders vorteilhaft hat sich eine Belegung zwischen 30% und 70% der Hartpartikeloberfläche 5 mit dem Haftmittler 2 erwiesen.

Nachdem die Hartpartikel 1 teilweise oder vollständig mit dem Haftmittler 2 beschichtet wurden, werden diese beschichteten/ummantelten Hartpartikel 1' in einem Atmosphärendruckplasma aktiviert und die aktivierten Hartpartikel 1' mit der Haftmittlerummantelung 2 auf eine Bauteiloberfläche 5 aufgebracht, um die reibwerterhöhende Beschichtung 3 bestehend aus den Hartpartikeln 1 und dem Haftmittler 2 auf dieser Bauteiloberfläche 5 abzuscheiden. Dabei wird eine Vorrichtung zur Atmosphärendruckplasma-Beschichtung verwendet wie sie z.B. in der DE°20°2007°019°184 U1 beschrieben wird. Bei der erfindungsgemäßen Atmosphärendruckplasma-Beschichtung wird das aus den ummantelten Hartpartikeln 1' bestehende Beschichtungspulver unter Ausschluss der Umgebungsluft mit einem Trägergas vermischt und in eine oder mehrere Reaktionszonen eines Plasmajets transportiert. In dieser Reaktionszone wird der Plasmastrahl und das Trägergas enthaltende Gas-/Partikelgemisch vermischt. Innerhalb dieses/dieser Reaktionsbereiche(s) wird die Plasmaenergie an den Gas-/Partikelstrom größtenteils übertragen.

Die Elektronen des Plasmastrahls zersputtern die metallische Ummantelung der eingespeisten Pulverpartikel und schmelzen diese aufgrund der dort noch relativ hohen Temperatur, insbesondere der hohen Elektronentemperatur, des Plasmas auf. Durch den Energieverbrauch für das Aufschmelzen und auf dem weiteren Weg des Plasmas zur Düsenöffnung kommt es zu einer Abkühlung, so dass das feinkörnige, die Beschichtung der Substratoberfläche bildende Pulver relativ kühl auf die Substratoberfläche gelangt. Die Substrattemperatur erhöht sich daher während der Atmosphärendruckplasma-Beschichtung nur wenig. Die Temperaturerhöhung des Substrates durch den Beschichtungsvorgang liegt während und unmittelbar nach dem Beschichtungsprozess mit dem feinkörnigen Pulver unterhalb von 100°C. Man spricht daher auch von einer nicht-thermischen Atmosphärendruckplasma-Beschichtung (ein nicht-thermisches Plasma wird auch als Niedertemperaturplasma bezeichnet). Gleichwohl wird bei Verwendung des nicht-thermischen Atmosphärendruckplasmas eine gute Haftung des aufgetragenen Pulvers erreicht. Die Substratoberfläche bedarf keiner speziellen Vorbehandlung. Die Oberflächenreinigung erfolgt durch den Plasmastrahl selbst.

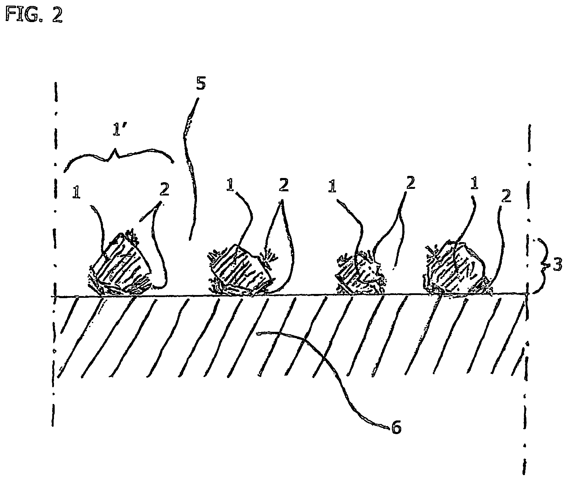

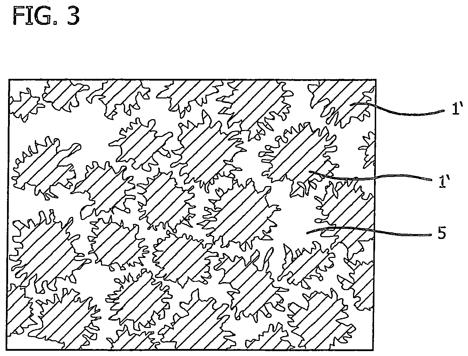

Nachdem das aktivierte Gemisch aus Trägergas und ummantelten Hartpartikeln 1' auf die Bauteiloberfläche 5 trifft, wird diese mit den ummantelten Hartpartikeln 1' beschichtet. Da dabei der Plasmastrahl selbst nur zu einem geringen Teil mit der Oberfläche 5 in direkten Kontakt kommt, werden die Strukturen und Eigenschaften der zu beschichtenden Oberfläche 5 bei der Atmosphärendruckplasma-Beschichtung nicht beschädigt und/oder nachhaltig beeinträchtigt. Die Haftungsmechanismen zwischen der aus den ummantelten Hartpartikeln 1' bestehenden reibwerterhöhenden Beschichtung und der Oberfläche 5 des damit beschichteten Bauteils 6 basieren auf dem für die Atmosphärendruckplasma-Beschichtungstechnologie zu Grunde liegenden Grenzflächeneffekte. Der Haftmittler 2 stellt die Bindephase zwischen der Oberfläche des Bauteils 6 und dem Hartpartikel 1 dar. Eine mit dem erfindungsgemäßen Verfahren hergestellte reibwerterhöhende Beschichtung 3 auf einer Bauteiloberfläche 5 ist im Querschnitt in Fig. 2 gezeigt und Fig. 3 zeigt eine Draufsicht auf die in Fig. 2 dargestellte reibwerterhöhende Beschichtung.

Die Haftung der Hartpartikel 1 auf der beschichteten Bauteiloberfläche 5 wird nach dem Aufbringen der reibwerterhöhenden Beschichtung 3 weiter verbessert durch eine nachgeschaltete Plasmaaktivierung der Oberfläche, bei der ein Plasmastrahl in direktem Kontakt mit der zu behandelnden Oberfläche ist und daher direkt auf die reibwerterhöhende Beschichtung 3 einwirkt.

Beim Fügen bzw. Verpressen einer Fügefläche 5 eines ersten Bauteils mit einer mit der reibwerterhöhenden Beschichtung 3 beschichteten Fügefläche 5 eines anderen Bauteils dringen die Hartstoffpartikel 1 in die Oberflächen der Fügeflächen 5 ein und übertragen die auftretenden Querkräfte direkt ohne dass der Haftmittler 2 an dieser Kraftübertragung beteiligt ist. Die verfügbare Normalkraft muss hierbei ausreichend sein, um die Hartpartikel 1 in die Oberflächen 5 der Bauteile (Fügeflächen) einzudrücken. Die Anzahl der Hartpartikel 1 pro Flächeneinheit der Kontaktflächen der zu fügenden Bauteile beträgt vorzugsweise zwischen 5% und 40% der Fügefläche 5. Bei einer geringeren Belegung der Fügeflächen mit Haftpartikeln 1 als 5% der Fügefläche können die zu erwartenden Querkräfte nicht sicher übertragen werden. Bei einer Flächenbelegung von mehr als 40% der Fügeflächen 5 ist in der Regel die verfügbare Normalkraft nicht mehr ausreichend, die Hartpartikel 1 in die Fügeflächen 5 ausreichend tief einzudrücken.

Anschließend an die Herstellung der reibwerterhöhenden Beschichtung 3 wie oben beschrieben wird die reibwerterhöhende Beschichtung 3 von lose aufsitzenden Hartpartikeln 1 befreit. Dies kann z.B. in einem Ultraschallbad oder aber durch Abblasen mit Druckluft erfolgen.

Die mit dem oben beschriebenen Verfahren hergestellte reibwerterhöhende Beschichtung 3 weist eine über die Verfahrensparameter reproduzierbare, definierte Anzahl an Hartpartikeln 1 auf. Die reibwerterhöhende Beschichtung 3 ist dadurch gekennzeichnet, dass über den an den Hartpartikeln angelagerten Haftmittler 2 während und nach dem Beschichtungsvorgang die Adhäsion zur Bauteiloberfläche 5 erfolgt. Bei dem Zusammenfügen einer beschichteten mit einer nicht beschichteten Bauteiloberfläche dringen die Hartpartikel 1 teilweise in die Fügeflächen 5 ein und führen zu einem Mikro-Formschluss. Dadurch erfolgt eine signifikante Erhöhung der erzielbaren Quer- und Scherkräfte gegenüber unbehandelten Oberflächen gleicher Materialpaarungen.

Zum Aufbringen der Beschichtung wurde wie folgt vorgegangen: Das zu beschichtende Werkstück (Schwungmasse) wurde in einer Vorrichtung positioniert. Bereiche der zu beschichtenden Fügefläche (Stirnseite) welche nicht in Kontakt mit den Beschichtungsmaterialien kommen durften (z.B. Verzahnungsbereich) wurden mit für das Atmosphärendruckplasma-Beschichtungsverfahren üblichen Methoden (z.B. Schattenmasken) geschützt.

Während des Beschichtungsvorgangs wurde die Schwungmasse mittels einer xy-Verfahreinheit unter der Beschichtungsdüse der Plasmaanlage in einem definierten Abstand und definierter Geschwindigkeit bewegt. Der eigentliche Beschichtungsvorgange erfolgte wie oben beschrieben. Durch die so erzeugte reibungswerterhöhende Beschichtung konnte bei der speziellen Ausführungsform der Haftbeiwert ν um einen Faktor 4 verbessert werden.

Bei der obigen Ausführungsform wurde der Beschichtungsvorgang mit einer xy-Verfahreinheit beschrieben. Jedoch kann auch eine beliebige andere Handhabungseinrichtung, z.B. ein 6-Achs-Roboter, verwendet werden. Alternativ kanndas zu beschichtende Bauteil (bei der speziellen Ausführungsform die Schwungmasse) auf einer Vorrichtung statisch positioniert und die Beschichtungsdüse der Plasmaanlage selbst über das zu beschichtende Bauteil bewegt werden.

Die obige Ausführungsform des erfindungsgemäßen Verfahrens wurde so beschrieben, dass der Plasmastrahl während der eigentlichen Abscheidung selbst nur zu einem geringen Teil mit der Oberfläche 5 in direkten Kontakt kommt und nach der eigentlichen Abscheidung eine nachgeschaltete Plasmaaktivierung durchgerührt wird. Es ist aber auch möglich, das Verfahren so durchzuführen, dass der Plasmastrahl während des Abscheidens mit der Oberfläche in Kontakt kommt. Je nach Einwirkzeit des Plasmastrahls auf die Oberfläche während der eigentlichen Abscheidung ist auch für diesen Fall eine nachgeschaltete Plasmaaktivierung vorteilhaft.

Als metallischer Haftmittler wurde bei der obigen Ausführungsform Nickel verwendet. Es ist jedoch auch möglich, andere Metalle, wie z.B. Kupfer als Haftmittler zu verwenden. Polymere als Haftmittler soweit thermisch beständig wären ebenfalls möglich.

## Patentansprüche

1. Verfahren zur Herstellung einer reibwerterhöhenden Beschichtung (3) auf einer Oberfläche (5) eines Bauteils (6) mittels nicht-thermischer Atmosphärendruckplasma-Beschichtung, wobei das Verfahren folgende Schritte aufweist:
a) Aktivieren von mit einem Haftmittler (2) teilweise oder vollständig ummantelten Hartpartikeln (1) in einem nicht thermischen Plasma unter Atmosphärendruck; und
b) Erzeugen der reibwerterhöhenden Bechichtung (3) auf der Oberfläche (5) des Bauteils (6) durch Abscheiden der mit dem nicht-thermischen Atmosphärendruck-Plasma aktivierten, mit dem Haftmittler (2) ummantelten Hartpartikel (1) auf der Oberfläche (5) des Bauteils (6).

2. Verfahren nach Anspruch 1, wobei die reibwerterhöhenden Hartpartikel (1) aus Diamant, Borcarbid oder Siliziumcarbid bestehen.

3. Verfahren nach Anspruch 1 oder 2, wobei der Haftmittler (2) ein Metall oder ein Polymer ist.

4. Verfahren nach einem der Ansprüche 1 bis 3, wobei die Belegung der Hartpartikel (1) mit Haftmittler (2) in Verfahrensschritt a) zwischen 20% und 80% der Hartpartikeloberfläche (4), besonders bevorzugt zwischen 30% und 70% der Hartpartikeloberfläche, beträgt.

5. Verfahren nach einem der Ansprüche 1 bis 4, wobei die Hartpartikel (1) einen mittleren Durchmesser von 3µm bis 45µm, besonders bevorzugt von 10µm bis 30µm, aufweisen.

6. Verfahren nach einem der Ansprüche 1 bis 5, wobei das Verfahren nach dem Schritt b) folgenden weiteren Verfahrensschritt aufweist:
c) Nachaktivierung der beschichteten Oberfläche (5) mittels eines Atmosphärendruckplasmas.

7. Verfahren nach einem der Ansprüche 1 bis 6, wobei die in Verfahrensschritt b) gebildete reibwerterhöhende Beschichtung (3) keine geschlossene Schicht zum Bauteil (6) bildet.

8. Verfahren nach einem der Ansprüche 1 bis 7, wobei die in Verfahrensschritt b) erzeugte reibwerterhöhende Beschichtung (3) auf der Oberfläche des Bauteils (6) eine gleichmäßige Flächenbelegung mit Hartpartikeln (1) zwischen 5% und 40%, besonders bevorzugt zwischen 10% und 30%, der Oberfläche (5) des Bauteils (6) bildet.

9. Verfahren nach einem der Ansprüche 1 bis 8, wobei die Temperaturerhöhung des Substrates durch den Beschichtungsvorgang während und unmittelbar nach dem Beschichtungsprozess unterhalb von 100°C liegt.

## Claims

1. A method for producing a coating (3) increasing the coefficient of friction on a surface (5) of an element (6) by means of a non-thermal atmospheric pressure plasma coating, wherein the method comprises the following steps:
a) activating of hard particles (1) partially or completely coated with a bonding agent (2) in a non-thermal plasma at atmospheric pressure; and
b) producing the coating (3) increasing the coefficient of friction on the surface (5) of the element (6) by depositing the hard particles activated by the non-thermal atmospheric plasma and coated by the bonding agent (2) on the surface (5) of the element (6).

2. The method according to claim 1, wherein the hard particles (1) increasing the coefficient of friction are made of diamond, boron carbide or silicon carbide.

3. The method according to claim 1 or 2, wherein the bonding agent (2) is a metal or a polymer.

4. The method according to any one of claims 1 to 3, wherein the coverage of the hard particles (1) with bonding agent (2) in method step a) is between 20 % and 80 % of the hard particle surface (4), more preferably between 30 % and 70 % of the hard particle surface.

5. The method according to any one of claims 1 to 4, wherein the hard particles (1) have an average diameter in a range from 3 µm to 45 µm, more preferably in a range from 10 µm to 30 µm.

6. The method according to any one of claims 1 to 5, wherein the method comprises the following method step after step b):
c) post-activating the coated surface (5) by means of an atmospheric pressure plasma.

7. The method according to any one of claims 1 to 6, wherein the coating (3) increasing the coefficient of friction formed in method step b) does not form a closed layer on the element (6).

8. The method according to any one of claims 1 to 7, wherein the coating (3) increasing the coefficient of friction produced in method step b) forms, on the surface of the element (6), a uniform coverage with hard particles (1) between 5 % and 40 %, more preferably between 10 % and 30 % of the surface (5) of the element (6).

9. The method according to any one of claims 1 to 8, wherein the temperature increase of the substrate by the coating process during and directly after the coating process is below 100 °C.

## Revendications

1. Procédé de fabrication d'un revêtement augmentant le coefficient de friction (3) sur une surface (5) d'un composant (6) au moyen d'un revêtement au plasma sous pression atmosphérique non thermique, dans lequel le procédé présente les étapes suivantes :
a) l'activation de particules dures (1) enveloppées partiellement ou complètement d'un agent d'adhérence (2) dans un plasma non thermique sous pression atmosphérique ; et
b) la génération du revêtement augmentant le coefficient de friction (3) sur la surface (5) du composant (6) par dépôt des particules dures (1) activées avec le plasma sous pression atmosphérique non thermique, enveloppées de l'agent d'adhérence (2) sur la surface (5) du composant (6).

2. Procédé selon la revendication 1, dans lequel les particules dures augmentant le coefficient de friction (1) consistent en diamant, carbure de bore ou carbure de silicium.

3. Procédé selon la revendication 1 ou 2, dans lequel l'agent d'adhérence (2) est un métal ou un polymère.

4. Procédé selon l'une des revendications 1 à 3, dans lequel le recouvrement des particules dures (1) avec l'agent d'adhérence (2) dans l'étape de procédé a) se situe entre 20 % et 80 % de la surface des particules dures (4), de manière particulièrement préférée entre 30 % et 70 % de la surface des particules dures.

5. Procédé selon l'une des revendications 1 à 4, dans lequel les particules dures (1) présentent un diamètre moyen de 3 µm à 45 µm, de manière particulièrement préférée de 10 µm à 30 µm.

6. Procédé selon l'une des revendications 1 à 5, dans lequel le procédé présente après l'étape b), l'autre étape de procédé suivante :
c) l'activation ultérieure de la surface (5) revêtue au moyen d'un plasma sous pression atmosphérique.

7. Procédé selon l'une des revendications 1 à 6, dans lequel le revêtement augmentant le coefficient de friction (3) formé dans l'étape de procédé b) ne forme pas de couche fermée par rapport au composant (6).

8. Procédé selon l'une des revendications 1 à 7, dans lequel le revêtement augmentant le coefficient de friction (3) généré dans l'étape de procédé b) forme sur la surface du composant (6) un recouvrement de surface uniforme avec des particules dures (1) entre 5 % et 40 %, de manière particulièrement préférée entre 10 % et 30 % de la surface (5) du composant (6).

9. Procédé selon l'une des revendications 1 à 8, dans lequel l'augmentation de la température du substrat par le processus de revêtement pendant et immédiatement après le processus de revêtement est inférieure à 100 °C.
